# EUROPEAN PATENT APPLICATION

(11) **EP 2 675 035 A1**
(43) Date of publication of application: **18.12.2013**
(21) Application number: 12007066.9
(22) Date of filing: 11.10.2012
(51) Int. Cl.: H02J 3/38, H01L 31/048

(54) **Photovoltaic power system with generation modules and method of controlling output power thereof**

(30) Priority: 30.05.2012 TW 101119253
(71) Applicant: Delta Electronics, Inc., Taoyuan County 32063 (TW)
(72) Inventor: Huang, Chi-Hsing, Taoyuan County 32063 (TW); Li, Sheng-Hua, Taoyuan County 32063 (TW)
(74) Representative: Ter Meer Steinmeister & Partner

(57) **Abstract**

A photovoltaic power generation module (10) has a photovoltaic panel assembly (100), a switch integrated apparatus (200), and a junction apparatus (300). The photovoltaic panel assembly (100) has a plurality of photovoltaic panels electrically connected in series. The switch integrated apparatus (200) has a control unit (2002) and a switch unit (2004). The junction apparatus (300) is electrically connected between the photovoltaic panel assembly (100) and the switch integrated apparatus (200) to collect power generated from the photovoltaic panels and deliver the collected power to output terminals of the photovoltaic power generation module (10). The control unit (2002) is controlled by a control signal sent from a communication unit (2010) to turn on or turn off the switch unit (2004) according to magnitude of the output voltage, thus controlling continuously transmitting the power or discontinuously transmitting the power generated from the photovoltaic panels.

## Description

### BACKGROUND OF THE INVENTION

### Field of the Invention

The present disclosure relates generally to a photovoltaic power system with generation modules and a method of controlling output power thereof, and more particularly to a photovoltaic power system with generation modules and a method of controlling output power thereof that is controlled to continuously deliver electricity or discontinuously deliver electricity generated from photovoltaic panels by turning on or turning off a switch unit.

### Description of Prior Art

The solar photovoltaic system provides a photovoltaic conversion to generate a DC power through the solar cell panels. Afterward, the DC power is converted into an AC power through a power conditioner to supply to a load or the converted AC power is grid-connected to an AC utility power through the utility grid bus. The solar photovoltaic system can be broadly divided into three categories: (1) stand-alone system, (2) grid-connection system, and (3) hybrid system.

The stand-alone system means that the solar photovoltaic system is completely operational without requiring external support and only directly supply to a load. Hence, the stand-alone system is generally built in remote areas or isolated islands. In particular, the required power electricity of a load is either the wind power or the solar power. The solar power or/and the wind power can further provide redundant power to charge the standby battery, whereas the load can be supplied through the battery when the solar power or/and the wind power is insufficient. The grid-connection system means that the solar photovoltaic system is further connected to the power grid of the electric power company. Hence, the grid-connection system is suitable for where the utility power can reach. When the amount of electricity generation of the solar photovoltaic system is greater than that of load demands, the redundant power remains would be delivered to the utility grid bus. On the other hand, the utility power can provide the required power electricity to a load when the amount of electricity generation of the solar photovoltaic system is insufficient. Furthermore, in order to improve the power supply reliability and quality, the hybrid system is developed. The solar photovoltaic system, which is combined with standby batteries, is temporarily separated from the utility power to provide power electricity to a load when the utility power fails. The solar photovoltaic system is further grid-connected to the utility grid bus until the utility power is available.

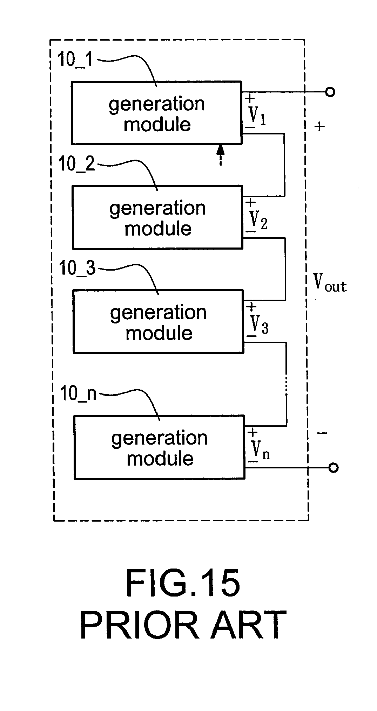

Because the photovoltaic electricity generation popularizes day after day, photovoltaic panels are usually installed on the roof to obtain the maximum of sunshine and light absorption efficiency. In addition, the grid-connection system is provided to feed back redundant power to the electric grid besides electricity for home use. Reference is made to Fig. 15 is a schematic block diagram of a prior art photovoltaic power system. The photovoltaic power system includes a plurality of generation modules 10_1∼10_n. It is assumed that each of the generation modules 10_1∼10_n can output about 40-volt DC voltage and the generation modules 10_1∼10_n are usually connected in series. Hence, the photovoltaic power system would output extremely large DC output voltage Vout. Once the photovoltaic power system is operated under bad environmental conditions or interrupted by the electric arcing produced due to old or degraded power lines to occur an open circuit condition at the DC output terminal, the open-circuit voltage will be up to 400 volts (if the amount of the generation modules 10_1∼10_n is ten). Therefore, the risk of electric shock will occur due to the extremely large DC output voltage. Speaking of the present photovoltaic power systems, the output voltage cannot be automatically reduced to zero volt when the fire accident occurs. In addition, the in-series generation modules 10_1∼10_n can not also be disconnected to each other. Accordingly, the existing disaster response strategy is that the houses with photovoltaic panels are completely destroyed and then the post-disaster treatment is executed to avoid firemen suffering the electric shock when the fire accident occurs and water is used for fire fighting. In addition, the disconnection of the photovoltaic panels can make construction workers operate at a low-voltage condition during the process of installing the photovoltaic panels to ensure the safety of lives and property.

Accordingly, it is desirable to provide a photovoltaic power system with generation modules and a method of controlling output power thereof to stop delivering electricity when the photovoltaic power system is operated under bad environmental conditions or interrupted by the electric arcing produced due to old or degraded power lines so that the photovoltaic power system can provide a fire cutting function to isolated itself from the caused fire accident due to extremely large DC high voltage.

### SUMMARY OF THE INVENTION

An object of the invention is to provide a generation module to solve the above-mentioned problems. Accordingly, the photovoltaic power system includes a photovoltaic panel assembly, a switch integrated apparatus, and a junction apparatus. The photovoltaic panel assembly has a plurality of photovoltaic panels electrically connected in series. The switch integrated apparatus has a control unit and a switch unit. The switch unit is electrically connected to the control unit. The junction apparatus is electrically connected between the photovoltaic panel assembly and the switch integrated apparatus and configured to collect electricity generated from the photovoltaic panels and configured to deliver collected electricity to an output terminal of the generation module. The control unit is configured to turn on or turn off the switch unit according to magnitude of an output voltage of the corresponding output terminal, thus controlling continuously delivering electricity or discontinuously delivering electricity generated from the photovoltaic panels.

Another object of the invention is to provide a photovoltaic power system to solve the above-mentioned problems. Accordingly, the photovoltaic power system includes a plurality of generation modules and a main communication apparatus. The generation modules are electrically connected in series. Each of the generation modules has a photovoltaic panel assembly, a switch integrated apparatus, and a junction apparatus. The photovoltaic panel assembly has a plurality of photovoltaic panels electrically connected in series. The switch integrated apparatus has a control unit and a switch unit. The junction apparatus is electrically connected between the photovoltaic panel assembly and the switch integrated apparatus and configured to collect electricity generated from the photovoltaic panels and configured to deliver collected electricity to an output terminal of the generation module. The main communication apparatus is connected to the switch integrated apparatus of the corresponding generation module and configured to turn on or turn off the switch unit according to magnitude of an output voltage of the corresponding output terminal, thus controlling continuously delivering electricity or discontinuously delivering electricity generated from the photovoltaic panels.

Further another object of the invention is to provide a method of controlling output power of a photovoltaic power system with generation modules to solve the above-mentioned problems. Accordingly, the method includes the following steps: (a) a plurality of generation modules are provided; the generation modules electrically connected in series, each of the generation modules having a photovoltaic panel assembly with a plurality of photovoltaic panels electrically connected in series; (b) a switch integrated apparatus is provided; the switch integrated apparatus having a control unit and a switch unit; (c) a junction apparatus installed in the generation module is provided; the junction apparatus electrically connected between the photovoltaic panel assembly and the switch integrated apparatus and configured to collect electricity generated from the photovoltaic panels and configured to deliver collected electricity to an output terminal of the generation module; and (d) the switch unit is turned on or turned off by the control unit according to magnitude of an output voltage of the corresponding output terminal, thus controlling continuously delivering electricity or discontinuously delivering electricity generated from the photovoltaic panels.

It is to be understood that both the foregoing general description and the following detailed description are exemplary, and are intended to provide further explanation of the invention as claimed. Other advantages and features of the invention will be apparent from the following description, drawings and claims.

### BRIEF DESCRIPTION OF DRAWING

The features of the invention believed to be novel are set forth with particularity in the appended claims. The invention itself, however, may be best understood by reference to the following detailed description of the invention, which describes an exemplary embodiment of the invention, taken in conjunction with the accompanying drawings, in which:
Fig. 1 is a schematic circuit block diagram of a photovoltaic generation module according to a first embodiment of the present disclosure;
Fig. 2 is a schematic circuit block diagram of the photovoltaic generation module according to a second embodiment of the present disclosure;
Fig. 3 is a schematic circuit block diagram of the photovoltaic generation module according to a third embodiment of the present disclosure;
Fig. 4 is a schematic circuit block diagram of the photovoltaic generation module according to a fourth embodiment of the present disclosure;
Fig. 5 is a schematic circuit block diagram of the photovoltaic generation module according to a fifth embodiment of the present disclosure;
Fig. 6 is a schematic circuit block diagram of the photovoltaic generation module according to a sixth embodiment of the present disclosure;
Fig. 7 is a schematic circuit block diagram of the photovoltaic generation module according to a seventh embodiment of the present disclosure;
Fig. 8 is a schematic circuit block diagram of the photovoltaic generation module according to an eighth embodiment of the present disclosure;
Fig. 9A is a schematic circuit block diagram of the photovoltaic generation module according to a ninth embodiment of the present disclosure;
Fig. 9B is a schematic circuit block diagram of the photovoltaic generation module according to a tenth embodiment of the present disclosure;
Fig. 10A is a schematic circuit block diagram of the photovoltaic generation module according to an eleventh embodiment of the present disclosure;
Fig. 10B is a schematic circuit block diagram of the photovoltaic generation module according to a twelfth embodiment of the present disclosure;
Fig. 11A is a schematic circuit block diagram of the photovoltaic generation module according to a thirteenth embodiment of the present disclosure;
Fig. 11B is a schematic circuit block diagram of the photovoltaic generation module according to a fourteenth embodiment of the present disclosure;
Fig. 12A is a schematic circuit block diagram of the photovoltaic generation module according to a fifteenth embodiment of the present disclosure;
Fig. 12B is a schematic circuit block diagram of the photovoltaic generation module according to a sixteenth embodiment of the present disclosure;
Fig. 13 is a schematic block diagram of a photovoltaic power system with generation modules according to the present disclosure;
Fig. 14 is a flowchart of a method of controlling output power of a photovoltaic power system with generation modules; and
Fig. 15 is a schematic block diagram of a prior art photovoltaic power system.

### DETAILED DESCRIPTION OF THE INVENTION

Reference will now be made to the drawing figures to describe the present invention in detail.

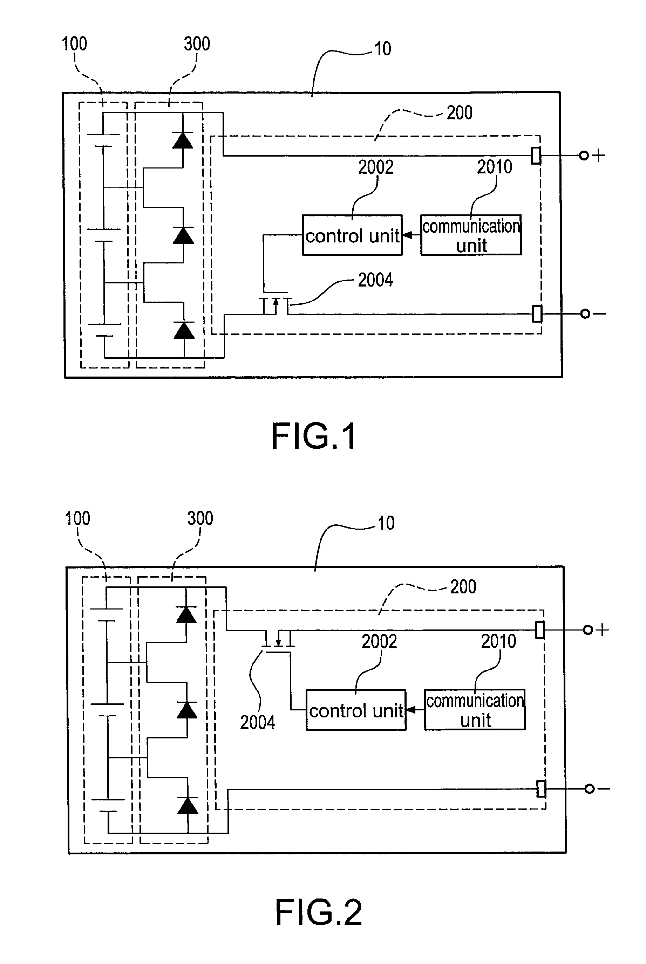

Reference is made to Fig. 1 which is a schematic circuit block diagram of a photovoltaic generation module according to a first embodiment of the present disclosure. The generation module 10 includes a photovoltaic panel assembly 100, a switch integrated apparatus 200, and a junction apparatus 300. The photovoltaic panel assembly 100 has a plurality of photovoltaic panels (not labeled) electrically connected in series. In this embodiment, the amount of the photovoltaic panels is three. The switch integrated apparatus 200 has a control unit 2002, a switch unit 2004, and a communication unit 2010. In this embodiment, the switch unit 2004 can be a metal-oxide-semiconductor field-effect transistor (MOSFET), but not intended to limit the scope of the disclosure. The junction apparatus 300 is electrically connected between the photovoltaic panel assembly 100 and the switch integrated apparatus 200 to collect electricity generated from the photovoltaic panels and to deliver collected electricity to an output terminal of the generation module 10. The control unit 2002 is used to control the switch unit 2004 to continue delivering or stop delivering electricity generated from the photovoltaic panels. The communication unit 2010 is electrically connected to the control unit 2002 to provide wired or wireless communications to the control unit 2002, thus controlling the switch unit 2004 to continue delivering or stop delivering electricity generated from the photovoltaic panels. Note that, the wireless communication can be the ZigBee protocol, the Wi-Fi protocol, or the blue tooth protocol. In addition, the wired communication can be the Ethernet protocol. However, the above-mentioned wired or wireless communication protocols are only exemplified but are not intended to limit the scope of the disclosure. The generation module 10 further includes an auxiliary power unit (not shown) electrically connected to the communication unit 2010 and to provide required electricity for the communication unit 2010. Especially, the junction apparatus 300 with in-series bypass diodes is provided to prevent hotspot effect because of shading.

In the first embodiment, the switch unit 2004 is connected in series to an output terminal of the junction apparatus 300. The generation module 10 continues delivering electricity generated from the photovoltaic panels when the control unit 2002 turns on the switch unit 2004, whereas the generation module 10 stops delivering electricity generated from the photovoltaic panels when the control unit 2002 turns off the switch unit 2004.

Reference is made to Fig. 2 which is a schematic circuit block diagram of the photovoltaic generation module according to a second embodiment of the present disclosure. The major difference between the above-mentioned first embodiment and the second embodiment is that the positions of connecting the switch unit 2004 to the junction apparatus 300 in series. However, the second embodiment can provide the equivalent feature to the first embodiment that is the switch unit 2004 is connected in series to the output terminal of the junction apparatus 300. Accordingly, the generation module 10 continues delivering electricity generated from the photovoltaic panels when the control unit 2002 turns on the switch unit 2004, whereas the generation module 10 stops delivering electricity generated from the photovoltaic panels when the control unit 2002 turns off the switch unit 2004.

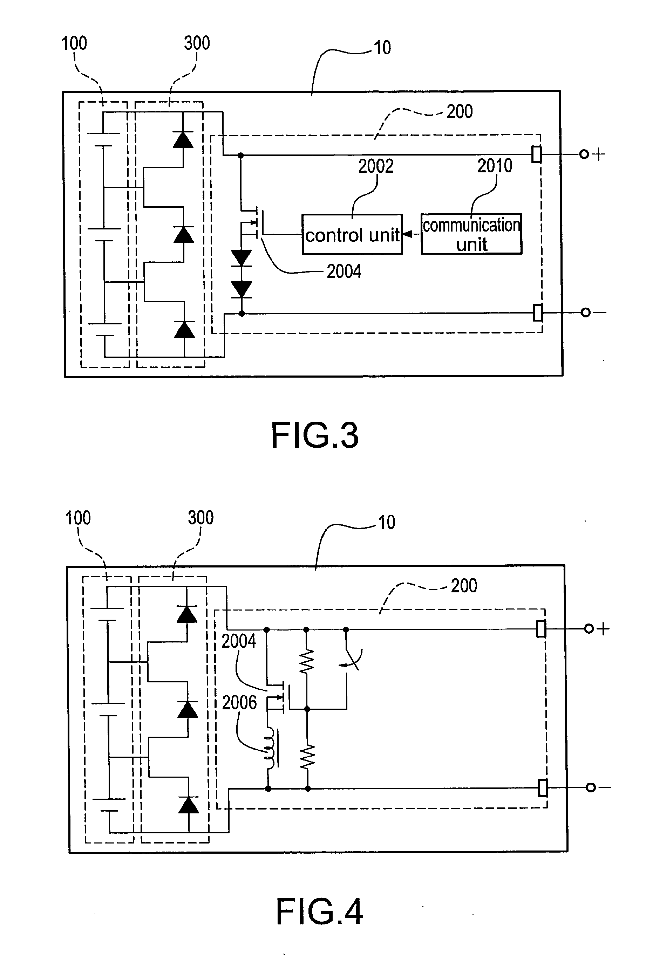

Reference is made to Fig. 3 which is a schematic circuit block diagram of the photovoltaic generation module according to a third embodiment of the present disclosure. The major difference between the above-mentioned first embodiment and the third embodiment is that the positions of connecting the switch unit 2004 to the junction apparatus 300 in parallel. Accordingly, the generation module 10 continues delivering electricity generated from the photovoltaic panels when the control unit 2002 turns off the switch unit 2004, whereas the generation module 10 stops delivering electricity generated from the photovoltaic panels when the control unit 2002 turns on the switch unit 2004. In addition, in this embodiment, the n-channel MOSFETs are exemplified as the switch unit 2004. The drain of the switch unit 2004 is usually connected to two diode elements in series and then to connected to the output terminal of the junction apparatus 300 in parallel. Accordingly, the polarity of the photovoltaic panel assembly 100 meets forward turned-on and reverse turned-off of the diode elements so as to ensure the direction of the conduction current when the switch unit 2004 and the diode elements are turned on. Also, the forward voltage across the diode elements can provide the sustained supply voltage for the switch unit 2004, the control unit 500, and the communication unit 600. Especially, the switch unit 2004 could be conductive in a short-circuit condition to make the output voltage of the generation module is nearly to the forward voltage across the diode elements because the generation module has a current-limited protective mechanism (not shown) inside thereof.

Reference is made to Fig. 4 which is a schematic circuit block diagram of the photovoltaic generation module according to a fourth embodiment of the present disclosure. The major difference between the above-mentioned third embodiment and the fourth embodiment is that the control unit 2002 and the communication unit 2010 are not required to be used in the switch integrated apparatus 200. Only a relay 2006 is used to connected to the switch unit 2004 in series and then connected to voltage-dividing resistors (not labeled) and a switch element (not labeled) to achieve the same effect as the third embodiment without using the control unit 2002 and the communication unit 2010. That is, the generation module 10 continues delivering electricity generated from the photovoltaic panels when the divided voltage of dividing an external voltage by the voltage-dividing resistors cannot turn on the switch unit 2004, whereas the generation module 10 stops delivering electricity generated from the photovoltaic panels when the divided voltage can turn on the switch unit 2004 to excite the relay 2006.

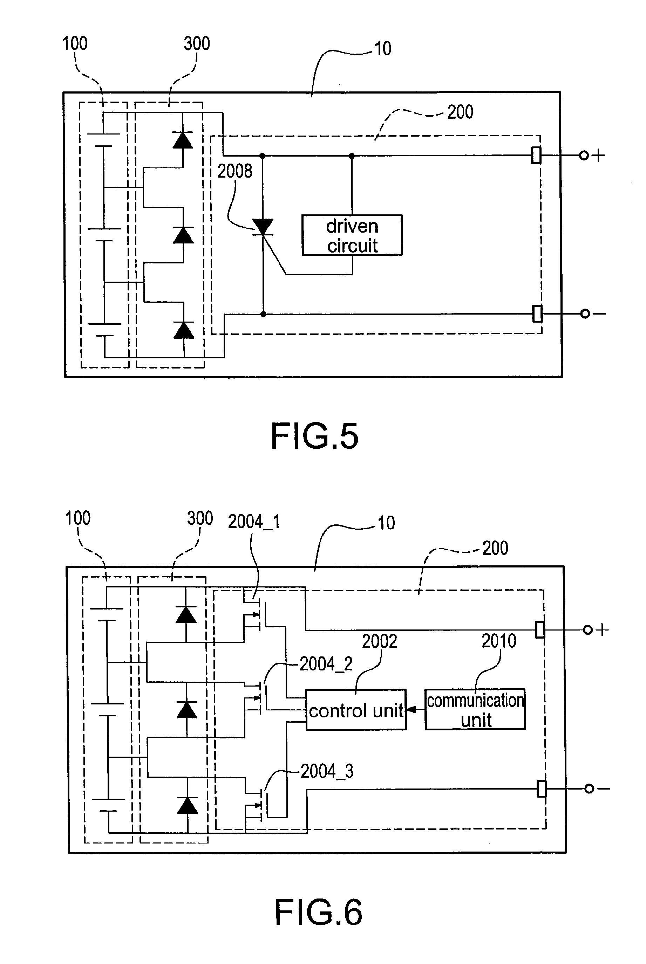

Reference is made to Fig. 5 which is a schematic circuit block diagram of the photovoltaic generation module according to a fifth embodiment of the present disclosure. The major difference between the above-mentioned third embodiment and the fifth embodiment is that the control unit 2002 and the communication unit 2010 are not required to be used in the switch integrated apparatus 200. Only a silicon controlled rectifier (SCR) 2008 is used to replace the switch unit 2004 and then is driven by a driven circuit (not labeled) to achieve the same effect as the third embodiment without using the control unit 2002 and the communication unit 2010. That is, the generation module 10 continues delivering electricity generated from the photovoltaic panels when the SCR 2008 is turned off, whereas the generation module 10 stops delivering electricity generated from the photovoltaic panels when the SCR 2008 is turned on.

Reference is made to Fig. 6 which is a schematic circuit block diagram of the photovoltaic generation module according to a sixth embodiment of the present disclosure. The major difference between the above-mentioned third embodiment and the sixth embodiment is that the amount of the switch units 2004 is the same that of the photovoltaic panels. In this embodiment, the switch units 2004_1∼2004_3 are connected to the corresponding photovoltaic panels in parallel. Accordingly, the switch units 2004_1∼2004_3 are respectively controlled by the control unit 2002 to adjust electricity generated from the photovoltaic panels of the generation module 10. That is, the generation module continuously and completely outputs electricity generated from the photovoltaic panels when the switch units 2004_1∼2004_3 are turned off, whereas the generation module stops delivering electricity generated from the photovoltaic panels when the switch units 2004_1∼2004_3 3 are turned on. In addition, the generation module only outputs electricity generated from the corresponding photovoltaic panel when the switch unit 2004_1 is turned off and other switch units 2004_2∼2004_3 are turned on. The rest conditions of turning on or turning off the switch units 2004_1∼2004_3 are similarly considered. Hence, the detail description is omitted here for conciseness.

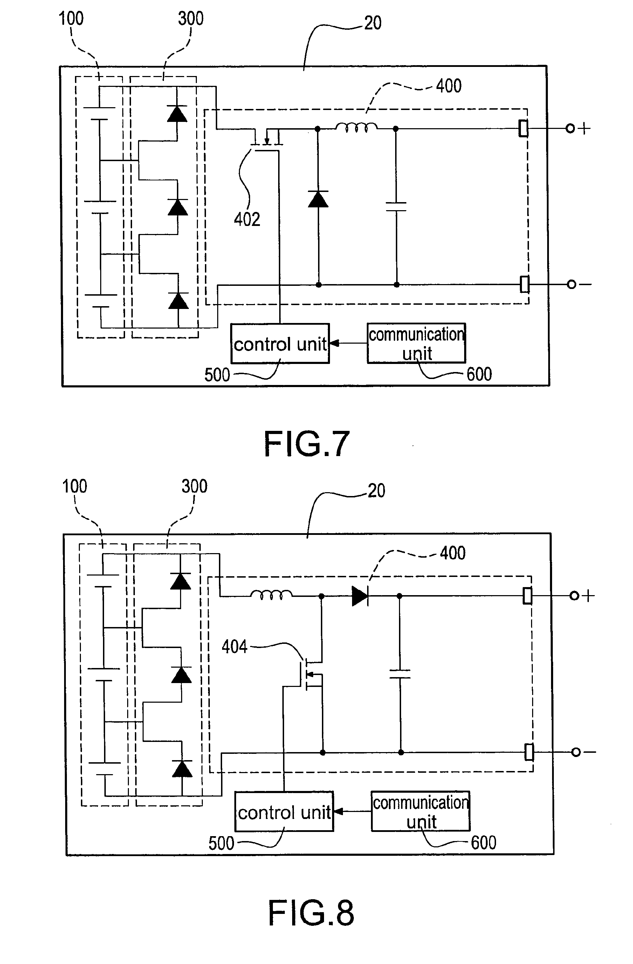

Reference is made to Fig. 7 which is a schematic circuit block diagram of the photovoltaic generation module according to a seventh embodiment of the present disclosure. The generation module 20 includes a photovoltaic panel assembly 100, a power conversion unit 400, a junction apparatus 300, a control unit 500, and a communication unit 600. The photovoltaic panel assembly 100 has a plurality of photovoltaic panels (not labeled) electrically connected in series. In this embodiment, the amount of the photovoltaic panels is three. The power conversion unit 400 has a switch element 402. The junction apparatus 300 is electrically connected between the photovoltaic panel assembly 100 and the power conversion unit 400 to collect electricity generated from the photovoltaic panels and to deliver collected electricity to an output terminal of the generation module 20. The communication unit 600 is electrically connected to the control unit 500 to provide wired or wireless communications to the control unit 500, thus controlling the switch element 402 to continue delivering or stop delivering electricity generated from the photovoltaic panels. Note that, the wireless communication can be the ZigBee protocol, the Wi-Fi protocol, or the blue tooth protocol. In addition, the wired communication can be the Ethernet protocol. However, the above-mentioned wired or wireless communication protocols are only exemplified but are not intended to limit the scope of the disclosure. The generation module 20 further includes an auxiliary power unit (not shown) electrically connected to the communication unit 600 and to provide required electricity for the communication unit 600. Especially, the power conversion unit 400 has the function of maximum power point tracking (MPPT) so as to control the output voltage and output current of the generation module 20 are operated at the maximum power point, thus providing the maximum output power. Note that, the communication unit 600 can provide wired or wireless communications to the control unit 500 to turn on or turn off the switch element 402 to stop delivering electricity generated from the photovoltaic panels when the photovoltaic power system is operated under emergency conditions. In particular, the priority of turning on or turning off the switch element 402 is higher than that of switching the switch element 402 for power conversion. That is, the switch element 402 is first used to stop delivering electricity generated from the photovoltaic panels when the photovoltaic power system occurs the emergency conditions. In this embodiment, the power conversion unit 400 is a buck converter so that the switch element 402 is connected in series to the output terminal of the junction apparatus 300. The communication unit 600 provides wired or wireless communications to the control unit 500. The generation module 20 continues delivering electricity generated from the photovoltaic panels when the control unit 500 turns on the switch element 402. On the other hand, the generation module 20 stops delivering electricity generated from the photovoltaic panels when the control unit 500 turns off the switch element 402. That is, in this embodiment, the switch element 402 of the buck converter is used without increasing additional switch elements to control continuously delivering electricity or discontinuously delivering electricity generated from the photovoltaic panels.

Reference is made to Fig. 8 which is a schematic circuit block diagram of the photovoltaic generation module according to an eighth embodiment of the present disclosure. The major difference between the above-mentioned seventh embodiment and the eighth embodiment is that the power conversion unit 400 is a boost converter so that so that the switch element 404 is connected in parallel to the output terminal of the junction apparatus 300. The communication unit 600 provides wired or wireless communications to the control unit 500. The generation module 20 continues delivering electricity generated from the photovoltaic panels when the control unit 500 turns off the switch element 404. On the other hand, the generation module 20 stops delivering electricity generated from the photovoltaic panels when the control unit 500 turns on the switch element 404. That is, in this embodiment, the switch element 404 of the boost converter is used without increasing additional switch elements to control continuously delivering electricity or discontinuously delivering electricity generated from the photovoltaic panels.

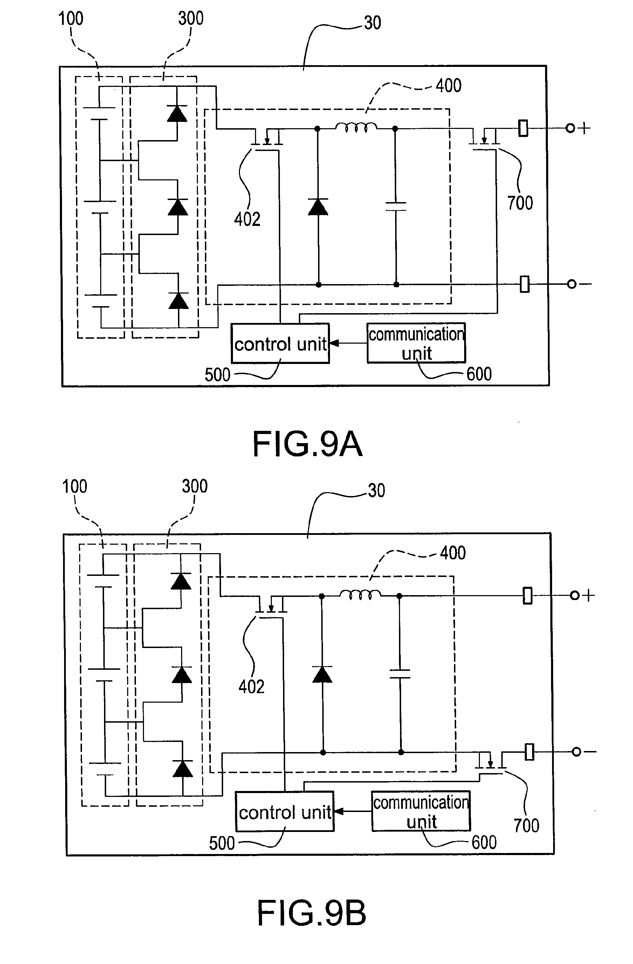

Reference is made to Fig. 9A which is a schematic circuit block diagram of the photovoltaic generation module according to a ninth embodiment of the present disclosure. The generation module 30 includes a photovoltaic panel assembly 100, a switch unit 700, a power conversion unit 400, a junction apparatus 300, a control unit 500, and a communication unit 600. The photovoltaic panel assembly 100 has a plurality of photovoltaic panels (not labeled) electrically connected in series. In this embodiment, the amount of the photovoltaic panels is three. The power conversion unit 400 has a switch element 402. The junction apparatus 300 is electrically connected between the photovoltaic panel assembly 100 and the power conversion unit 400 to collect electricity generated from the photovoltaic panels and deliver collected electricity to an output terminal of the generation module 30. The communication unit 600 is electrically connected to the control unit 500 to provide wire or wireless communications to the control unit 500 to turn on or turn off the switch unit 700 and the switch element 402, thus controlling continuously delivering electricity or discontinuously delivering electricity generated from the photovoltaic panels. Note that, the wireless communication can be the ZigBee protocol, the Wi-Fi protocol, or the blue tooth protocol. In addition, the wired communication can be the Ethernet protocol. However, the above-mentioned wired or wireless communication protocols are only exemplified but are not intended to limit the scope of the disclosure. In addition, the generation module 20 further includes an auxiliary power unit (not shown) electrically connected to the communication unit 600 to provide the required electricity for the communication unit 600.

In this embodiment, the power conversion unit 400 is a buck converter so that the switch element 402 is connected in series to an output terminal of the junction apparatus 300. Also, the switch unit 700 is connected in series to an output terminal of the power conversion unit 400. The communication unit 600 provides wired or wireless communications to the control unit 500. The generation module 30 continues delivering electricity generated from the photovoltaic panels when the control unit 500 turns on the switch element 402 and simultaneously turns on the switch unit 700. On the other hand, the generation module 30 stops delivering electricity generated from the photovoltaic panels when the control unit 500 turns off the switch element 402 or turns off the switch unit 700. As shown in Fig. 9A, the switch unit 700 is connected to a negative electrode of the output terminal of the generation module 30. Especially, the switch unit 700 can be also connected to a positive electrode of the output terminal of the generation module 30 (not shown) to be another embodiment of the present disclosure.

Reference is made to Fig. 9B which is a schematic circuit block diagram of the photovoltaic generation module according to a tenth embodiment of the present disclosure. The major difference between the above-mentioned ninth embodiment and the tenth embodiment is that the switch unit 700 is connected in series to the output terminal of the junction apparatus 300. In other words, the tenth embodiment can provide the equivalent features to the ninth embodiment even though the connection locations of the switch unit 700 are different between the two embodiments. As shown in Fig. 9B, the switch unit 700 is connected to the output terminal of the junction apparatus 300 corresponding to the negative electrode of the output terminal of the generation module 30. Especially, the switch unit 700 can be also connected to the output terminal of the junction apparatus 300 corresponding to the positive electrode of the output terminal of the generation module 30 (not shown) to be another embodiment of the present disclosure.

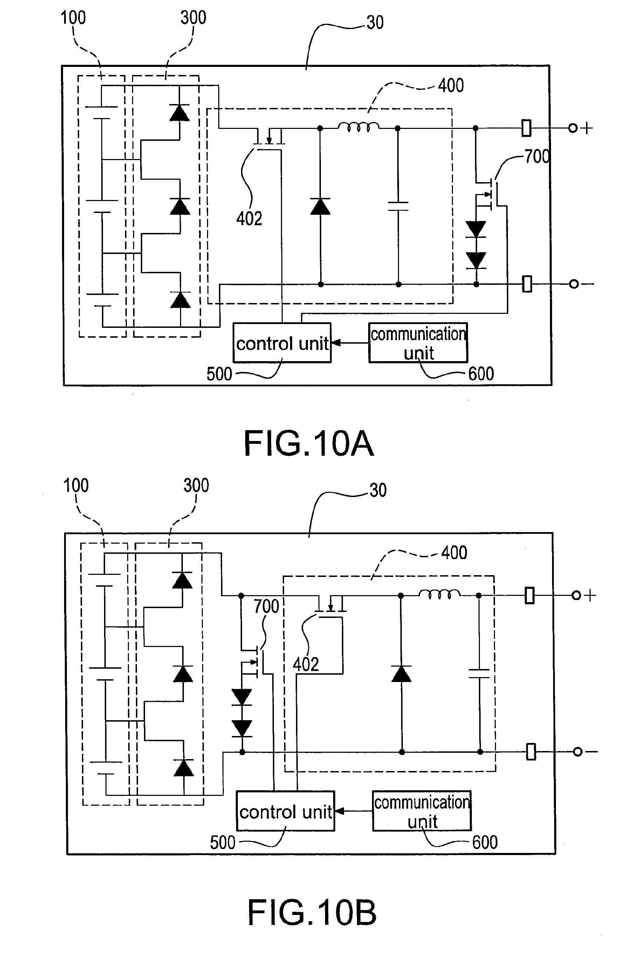

Reference is made to Fig. 10A which is a schematic circuit block diagram of the photovoltaic generation module according to an eleventh embodiment of the present disclosure. The major difference between the above-mentioned ninth embodiment and the eleventh embodiment is that the switch unit 700 is connected in parallel to the output terminal of the power conversion unit 400. The communication unit 600 provides wired or wireless communications to the control unit 500. The generation module 30 continues delivering electricity generated from the photovoltaic panels when the control unit 500 turns on the switch element 402 and simultaneously turns off the switch unit 700. On the other hand, the generation module 30 stops delivering electricity generated from the photovoltaic panels when the control unit 500 turns off the switch element 402 or turns on the switch unit 700.

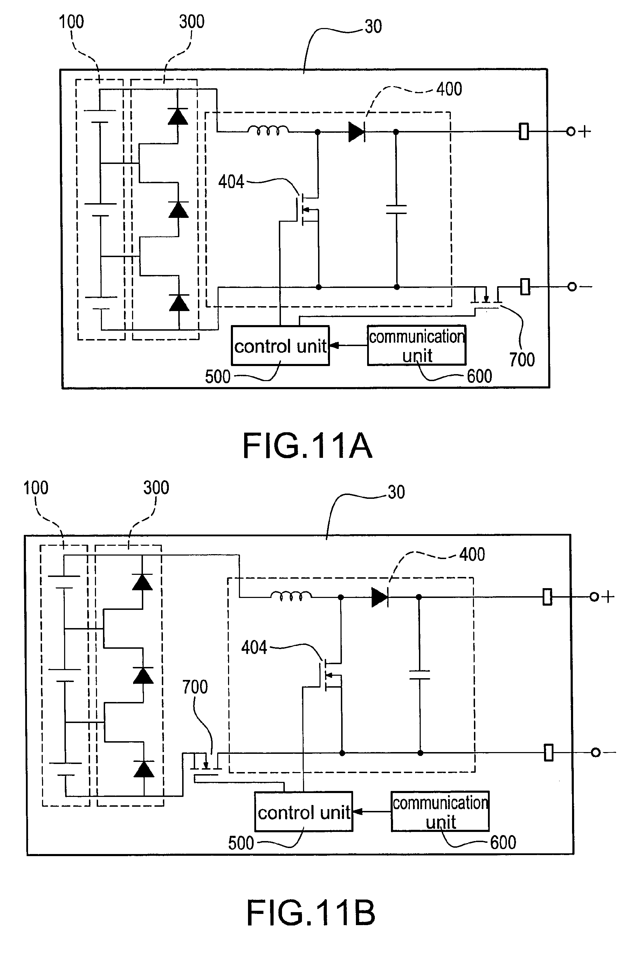

Reference is made to Fig. 10B which is a schematic circuit block diagram of the photovoltaic generation module according to a twelfth embodiment of the present disclosure. The major difference between the above-mentioned eleventh embodiment and the twelfth embodiment is that the switch unit 700 is connected in parallel to the output terminal of the junction apparatus 300. In other words, the twelfth embodiment can provide the equivalent features to the eleventh embodiment even though the connection locations of the switch unit 700 are different between the two embodiments. Reference is made to Fig. 11A which is a schematic circuit block diagram of the photovoltaic generation module according to a thirteenth embodiment of the present disclosure. The major difference between the above-mentioned ninth embodiment and the thirteenth embodiment is that the power conversion unit 400 is a boost converter so that the switch element 404 is connected in parallel to the output terminal of the junction apparatus 300. The communication unit 600 provides wired or wireless communications to the control unit 500. The generation module 30 continues delivering electricity generated from the photovoltaic panels when the control unit 500 turns off the switch element 404 and simultaneously turns on the switch unit 700. On the other hand, the generation module 30 stops delivering electricity generated from the photovoltaic panels when the control unit 500 turns on the switch element 404 or turns off the switch unit 700.

Reference is made to Fig. 11B which is a schematic circuit block diagram of the photovoltaic generation module according to a fourteenth embodiment of the present disclosure. The major difference between the above-mentioned thirteenth embodiment and the fourteenth embodiment is that the switch unit 700 is connected in series to the output terminal of the junction apparatus 300. In other words, the fourteenth embodiment can provide the equivalent features to the thirteenth embodiment even though the connection locations of the switch unit 700 are different between the two embodiments. As shown in Fig. 11B, the switch unit 700 is connected to the output terminal of the junction apparatus 300 corresponding to the negative electrode of the output terminal of the generation module 30. Especially, the switch unit 700 can be also connected to the output terminal of the junction apparatus 300 corresponding to the positive electrode of the output terminal of the generation module 30 (not shown) to be another embodiment of the present disclosure.

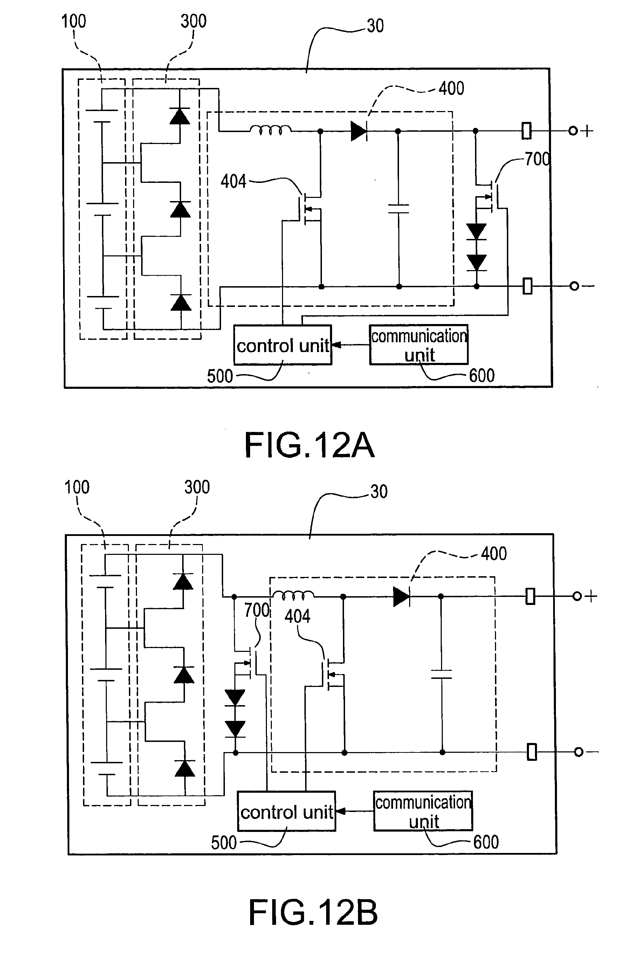

Reference is made to Fig. 12A which is a schematic circuit block diagram of the photovoltaic generation module according to a fifteenth embodiment of the present disclosure. The major difference between the above-mentioned thirteenth embodiment and the fifteenth embodiment is that the switch unit 700 is connected in parallel to the output terminal of the power conversion unit 400. The communication unit 600 provides wired or wireless communications to the control unit 500. The generation module 30 continues delivering electricity generated from the photovoltaic panels when the control unit 500 turns off the switch element 404 and simultaneously turns off the switch unit 700. On the other hand, the generation module 30 stops delivering electricity generated from the photovoltaic panels when the control unit 500 turns on the switch element 404 or turns on the switch unit 700.

Reference is made to Fig. 12B which is a schematic circuit block diagram of the photovoltaic generation module according to a sixteenth embodiment of the present disclosure. The major difference between the above-mentioned fifteenth embodiment and the sixteenth embodiment is that the switch unit 700 is connected in parallel to the output terminal of the junction apparatus 300. In other words, the sixteenth embodiment can provide the equivalent features to the fifteenth embodiment even though the connection locations of the switch unit 700 are different between the two embodiments.

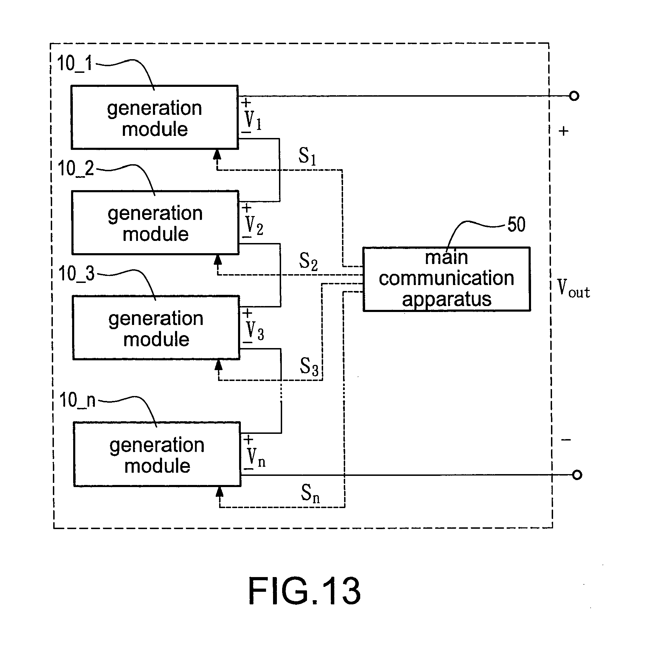

Reference is made to Fig. 13 which is a schematic block diagram of a photovoltaic power system with generation modules according to the present disclosure. The photovoltaic power system includes a plurality of generation modules 10_1∼10_n and a main communication apparatus 50. The generation modules 10_1∼10_n are electrically connected in series and each of the generation modules 10_1∼10_n generates a corresponding module output voltage V1∼Vn. Note that, a system output voltage Vout provided from the photovoltaic power system is equal to the sum of the module output voltages V1∼Vn.

Each of the generation modules 10_1∼10_n has a photovoltaic panel assembly, a switch integrated apparatus, a junction apparatus, and a communication unit (not shown). In particular, the circuit connections and circuit structures of these apparatuses can refer to the above-mentioned descriptions. Especially, the main communication apparatus 50 is optionally connected to the switch integrated apparatus of each generation modules 10_1∼10_n to turn on or turn off the switch unit according to magnitude of the corresponding output voltage V1-Vn of each generation modules 10_1∼10_n, thus controlling continuously delivering electricity or discontinuously delivering electricity generated from the photovoltaic panels. That is, when the photovoltaic power system is operated under bad environmental conditions or interrupted by the electric arcing produced due to old or degraded power lines, the main communication apparatus 50 synchronously provides the corresponding main control signals S1∼Sn to turn on or turn off the switch unit according to the circuit topologies inside the generation modules to disconnect the in-series generation modules 10_1∼10_n to each other, thus providing a fire cutting function to isolated itself from the caused fire accident due to extremely large DC high voltage. On the other hand, when the bad environmental conditions are removed, the main communication apparatus 50 synchronously provides the corresponding main control signals S1∼Sn to turn on or turn off the switch unit to connect the generation modules 10_1∼10_n in series to each other, thus continuously delivering electricity or discontinuously delivering electricity generated from the photovoltaic panels. Note that, the main control signals S1∼Sn can be warning signals to disconnect the generation modules 10_1∼10_n once the photovoltaic power system occurs the emergency conditions, whereas the main control signals S1∼Sn can be recovery signals to connect the generation modules 10_1∼10_n once the emergency conditions are removed.

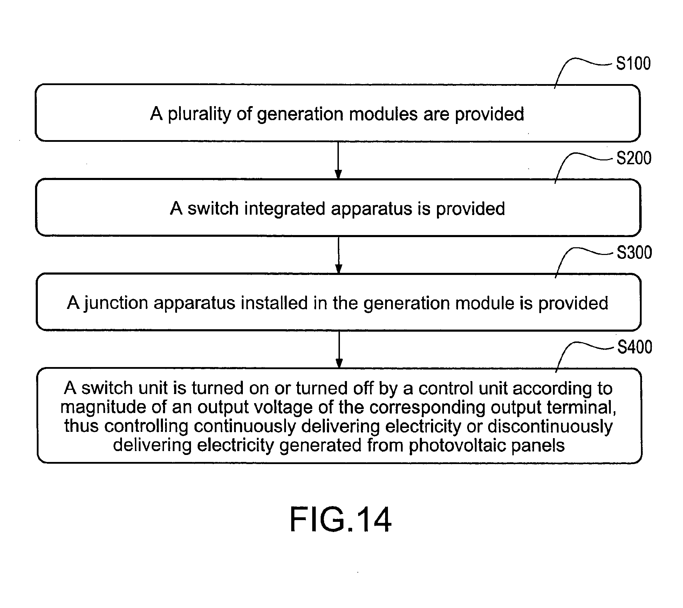

Reference is made to Fig. 14 which is a flowchart of a method of controlling output power of a photovoltaic power system with generation modules. The method includes the following steps: first, a plurality of generation modules are provided (S100); the generation modules electrically connected in series, each of the generation modules having a photovoltaic panel assembly with a plurality of photovoltaic panels electrically connected in series. Afterward, a switch integrated apparatus is provided (S200); the switch integrated apparatus having a control unit and a switch unit. Afterward, a junction apparatus installed in the generation module is provided (S300); the junction apparatus electrically connected between the photovoltaic panel assembly and the switch integrated apparatus and to collect electricity generated from the photovoltaic panels and to deliver collected electricity to an output terminal of the generation module. Finally, the switch unit is turned on or turned off by the control unit according to magnitude of an output voltage of the corresponding output terminal, thus controlling continuously delivering electricity or discontinuously delivering electricity generated from the photovoltaic panels (S400).

The switch unit is connected in parallel to an output terminal of the junction apparatus; the generation module continues delivering electricity generated from the photovoltaic panels when the control unit turns off the switch unit; the generation module stops delivering electricity generated from the photovoltaic panels when the control unit turns on the switch unit.

In addition, the switch unit is connected in series to the output terminal of the junction apparatus; the generation module continues delivering electricity generated from the photovoltaic panels when the control unit turns on the switch unit; the generation module stops delivering electricity generated from the photovoltaic panels when the control unit turns off the switch unit.

In the step (S200), the switch integrated apparatus further includes a communication unit and an auxiliary power unit. The communication unit is electrically connected to the control unit to provide wired or wireless communications to the control unit, thus turning on or turning off the switch unit. The auxiliary power unit is electrically connected to the communication unit to provide required electricity for the communication unit.

The switch unit is connected in parallel to an output terminal of the junction apparatus; the generation module continues delivering electricity generated from the photovoltaic panels when the control unit turns off the switch unit; the generation module stops delivering electricity generated from the photovoltaic panels when the control unit turns on the switch unit.

In addition, the switch unit is connected in series to the output terminal of the junction apparatus; the generation module continues delivering electricity generated from the photovoltaic panels when the control unit turns on the switch unit; the generation module stops delivering electricity generated from the photovoltaic panels when the control unit turns off the switch unit.

## Claims

1. A generation module (10), comprising:
a photovoltaic panel assembly (100) having a plurality of photovoltaic panels electrically connected in series;
a switch integrated apparatus (200) having:
a control unit (2002); and
a switch unit (2004) electrically connected to the control unit (2002);
a junction apparatus (300) electrically connected between the photovoltaic panel assembly (100) and the switch integrated apparatus (200) and configured to collect electricity generated from the photovoltaic panels and configured to deliver collected electricity to an output terminal of the generation module (10);
wherein the control unit (2002) is configured to turn on or turn off the switch unit (2004) according to magnitude of an output voltage of the corresponding output terminal, thus controlling continuously delivering electricity or discontinuously delivering electricity generated from the photovoltaic panels.

2. The generation module in claim 1, wherein the switch integrated apparatus (200) further comprising:
a communication unit (2010) electrically connected to the control unit (2002) and the switch unit (2004) according to magnitude of an output voltage of the corresponding output terminal; the communication unit (2010) controlled by a main control signal (S1∼Sn) produced from an external main communication apparatus (50) and configured to send a control signal to the control unit (2002) for turning on or turning off the switch unit (2004); and
an auxiliary power unit electrically connected to the communication unit (2010) and configured to provide required electricity for the communication unit (2010).

3. The generation module in claim 1, wherein the switch unit (2004) is connected in parallel to an output terminal of the junction apparatus (300); the generation module (10) is configured to continue delivering electricity generated from the photovoltaic panels when the control unit (2002) is configured to turn off the switch unit (2004); the generation module (10) is configured to stop delivering electricity generated from the photovoltaic panels when the control unit (2002) is configured to turn on the switch unit (2004).

4. The generation module in claim 1, wherein the switch unit (2004) is connected in series to an output terminal of the junction apparatus (300); the generation module (10) is configured to continue delivering electricity generated from the photovoltaic panels when the control unit (2002) is configured to turn on the switch unit (2004); the generation module (10) is configured to stop delivering electricity generated from the photovoltaic panels when the control unit (2002) is configured to turn off the switch unit (2004).

5. The generation module in claim 2, wherein the switch unit (2004) is connected in parallel to an output terminal of the junction apparatus (300); the generation module (10) is configured to continue delivering electricity generated from the photovoltaic panels when the control unit (2002) is configured to turn off the switch unit (2004); the generation module (10) is configured to stop delivering electricity generated from the photovoltaic panels when the control unit (2002) is configured to turn on the switch unit (2004); wherein the switch unit (2004) is connected in series to an output terminal of the junction apparatus (300); the generation module (10) is configured to continue delivering electricity generated from the photovoltaic panels when the control unit (2002) is configured to turn on the switch unit (2004); the generation module (10) is configured to stop delivering electricity generated from the photovoltaic panels when the control unit (2002) is configured to turn off the switch unit (2004).

6. A photovoltaic power system, comprising:
a plurality of generation modules (10_1∼10_n) electrically connected in series, each of the generation modules (10_1∼10_n) having:
a photovoltaic panel assembly (100) having a plurality of photovoltaic panels electrically connected in series;
a switch integrated apparatus (200) having:
a control unit (2002); and
a switch unit (2004) electrically connected to the control unit (2002);
a junction apparatus (300) electrically connected between the photovoltaic panel assembly (100) and the switch integrated apparatus (200) and configured to collect electricity generated from the photovoltaic panels and configured to deliver collected electricity to an output terminal of the generation module (10_1∼10_n); and
a main communication apparatus (50) connected to the switch integrated apparatus (200) of the corresponding generation module (10_1∼10_n) and configured to turn on or turn off the switch unit (2004) according to magnitude of an output voltage of the corresponding output terminal, thus controlling continuously delivering electricity or discontinuously delivering electricity generated from the photovoltaic panels.

7. The photovoltaic power system in claim 6, wherein the switch integrated apparatus (200) further comprising:
a communication unit (2010) electrically connected to the control unit (2002) and the switch unit (2004) and configured to provide wired or wireless communications to the control unit (2002), thus turning on or turning off the switch unit (2004); and
an auxiliary power unit electrically connected to the communication unit (2010) and configured to provide required electricity for the communication unit (2010).

8. The photovoltaic power system in claim 6, wherein the switch unit (2004) is connected in parallel to an output terminal of the junction apparatus (300); the generation module (10_1∼10_n) is configured to continue delivering electricity generated from the photovoltaic panels when the control unit (2002) is configured to turn off the switch unit (2004); the generation module (10_1∼10_n) is configured to stop delivering electricity generated from the photovoltaic panels when the control unit (2002) is configured to turn on the switch unit (2004).

9. The photovoltaic power system in claim 6, wherein the switch unit (2004) is connected in series to an output terminal of the junction apparatus (300); the generation module (10_1∼10_n) is configured to continue delivering electricity generated from the photovoltaic panels when the control unit (2002) is configured to turn on the switch unit (2004); the generation module (10_1∼10_n) is configured to stop delivering electricity generated from the photovoltaic panels when the control unit (2002) is configured to turn off the switch unit (2004).

10. The photovoltaic power system in claim 7, wherein the switch unit (2004) is connected in parallel to an output terminal of the junction apparatus (300); the generation module (10_1∼10_n) is configured to continue delivering electricity generated from the photovoltaic panels when the control unit (2002) is configured to turn off the switch unit (2004); the generation module (10_1∼10_n) is configured to stop delivering electricity generated from the photovoltaic panels when the control unit (2002) is configured to turn on the switch unit (2004); wherein the switch unit (2004) is connected in series to an output terminal of the junction apparatus (300); the generation module (10_1∼10_n) is configured to continue delivering electricity generated from the photovoltaic panels when the control unit (2002) is configured to turn on the switch unit (2004); the generation module (10_1∼10_n) is configured to stop delivering electricity generated from the photovoltaic panels when the control unit (2002) is configured to turn off the switch unit (2004).

11. A method of controlling output power of a photovoltaic power system with generation modules; steps of the method comprising:
(a) providing a plurality of generation modules (S100); the generation modules electrically connected in series, each of the generation modules having a photovoltaic panel assembly with a plurality of photovoltaic panels electrically connected in series;
(b) providing a switch integrated apparatus (S200); the switch integrated apparatus having a control unit and a switch unit;
(c) providing a junction apparatus installed in the generation module (S300); the junction apparatus electrically connected between the photovoltaic panel assembly and the switch integrated apparatus and configured to collect electricity generated from the photovoltaic panels and configured to deliver collected electricity to an output terminal of the generation module; and
(d) turning on or turning off the switch unit by the control unit according to magnitude of an output voltage of the corresponding output terminal, thus controlling continuously delivering electricity or discontinuously delivering electricity generated from the photovoltaic panels (S400).

12. The method of controlling output power in claim 11, wherein the switch integrated apparatus further comprising:
a communication unit electrically connected to the control unit and the switch unit according to magnitude of an output voltage of the corresponding output terminal; the communication unit controlled by a main control signal produced from an external main communication apparatus and configured to send a control signal to the control unit for turning on or turning off the switch unit; and
an auxiliary power unit electrically connected to the communication unit and configured to provide required electricity for the communication unit.

13. The method of controlling output power in claim 11, wherein the switch unit is connected in parallel to an output terminal of the junction apparatus; the generation module is configured to continue delivering electricity generated from the photovoltaic panels when the control unit is configured to turn off the switch unit; the generation module is configured to stop delivering electricity generated from the photovoltaic panels when the control unit is configured to turn on the switch unit.

14. The method of controlling output power in claim 11, wherein the switch unit is connected in series to an output terminal of the junction apparatus; the generation module is configured to continue delivering electricity generated from the photovoltaic panels when the control unit is configured to turn on the switch unit; the generation module is configured to stop delivering electricity generated from the photovoltaic panels when the control unit is configured to turn off the switch unit.

15. The method of controlling output power in claim 12, wherein the switch unit is connected in parallel to an output terminal of the junction apparatus; the generation module is configured to continue delivering electricity generated from the photovoltaic panels when the control unit is configured to turn off the switch unit; the generation module is configured to stop delivering electricity generated from the photovoltaic panels when the control unit is configured to turn on the switch unit; wherein the switch unit is connected in series to an output terminal of the junction apparatus; the generation module is configured to continue delivering electricity generated from the photovoltaic panels when the control unit is configured to turn on the switch unit; the generation module is configured to stop delivering electricity generated from the photovoltaic panels when the control unit is configured to turn off the switch unit.
